# EUROPEAN PATENT APPLICATION

(11) **EP 2 067 594 A1**
(43) Date of publication of application: **10.06.2009**
(21) Application number: 07807460.6
(22) Date of filing: 18.09.2007
(51) Int. Cl.: B29C 33/38, B29C 67/00, C08F 212/04, C08F 220/04

(54) **METHOD FOR MANUFACTURING MOLDING DIE AND METHOD FOR MANUFACTURING MOLDED PRODUCT**

(30) Priority: 27.09.2006 JP 2006263066
(71) Applicant: JSR Corporation, Tokyo 105-8640 (JP)
(72) Inventor: TAKASE, Katsuyuki c/o JSR Corporation, Tokyo 105-8640 (JP); MOROHOSHI, Kimitaka c/o JSR Corporation, Tokyo 105-8640 (JP); TERAMOTO, Toshio c/o JSR Corporation, Tokyo 105-8640 (JP)
(74) Representative: TBK-Patent
(86) International application number: PCT/JP2007/068059
(87) International publication number: WO 2008/038540

(57) **Abstract**

An object of the present invention is to provide a metal mold for micro components at low cost in a short time by using an optically molded object formed by an optical molding method. A method of manufacturing a mold for molding in accordance with the present invention includes forming a three-dimensional molded object by applying a photo-curable liquid resin composition, irradiating the photo-curable liquid resin composition with light, and removing non-cured portions of the photo-curable liquid resin composition, and forming the mold for molding based on the three-dimensional molded object, the method further including forming a metal coating covering the three-dimensional molded object, removing the three-dimensional molded object covered with the metal coating; and taking the metal coating as the mold for molding.

## Description

### Technical Field

The present invention relates to a method of manufacturing a mold for molding and a method of manufacturing a molded article, and in particular to a method of manufacturing a metal mold using an optically molded object formed by an optical molding method.

### Background Art

In recent years, miniaturization, weight reduction, and performance improvement have been strongly desired in various electronic devices, typified by mobile terminals and the likes. Therefore, it has been increasingly desired to miniaturize mechanical components for use in electronic devices, such as screws, cogwheels, housings for motors, and springs. Note that the uses of minute mechanical components (hereinafter called "micro mechanical components") are not limited to various electronic devices and various apparatuses, but also include the application to the whole range of various structures. As described above, to manufacture micro mechanical components in a large quantity, a metal mold having an inverted shape of an object to be manufactured is used. The metal mold is a mold form used to mold and process material such as metal, plastic, rubber, and glass into a designed shape.

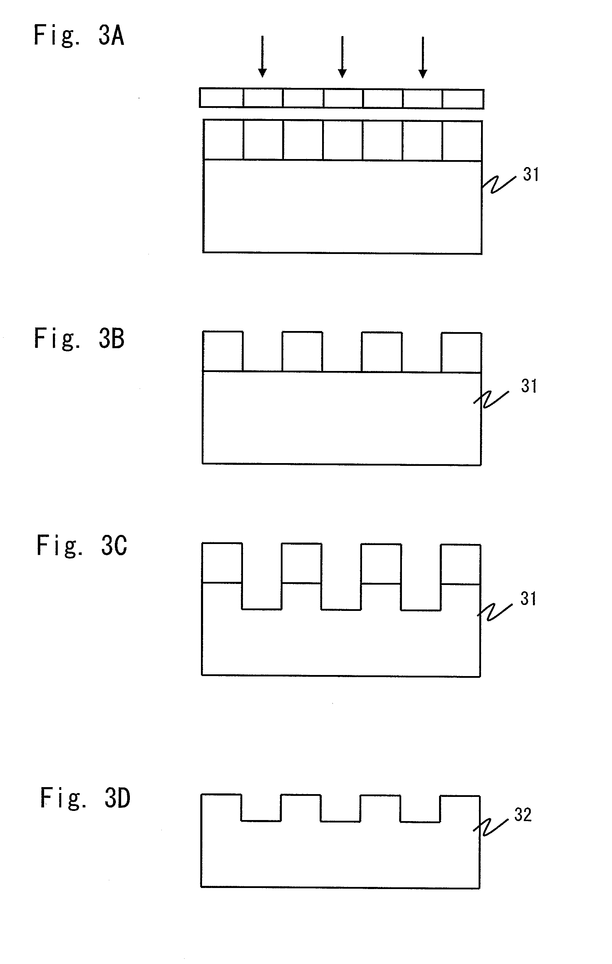

In these days, a minute metal mold is manufactured by the lithography process (exposure technique), which has been originally used in a semiconductor process. Figs 3A to 3D show a method of manufacturing a minute metal mold (hereinafter, simply called "conventional metal mold") described in a related art. Firstly, a pattern is transferred to and burned on a substrate 31 through a photomask (see Fig. 3A). Then, portions that are irradiated with light are removed by dissolving the exposure portions with a chemical agent or the like (see Fig. 3B). After the light radiation portions are removed, etching is performed (see Fig. 3C). The manufacture of the master plate of a conventional metal mold 32 is completed in this way (see Fig. 3D). A typical conventional metal mold 32 has been manufactured in processes described above.

This lithography process requires multistage process. Therefore, the manufacturing of a conventional metal mold by using the lithography process takes a large number of manufacturing days. Furthermore, the lithography process is also very expensive. The manufacturing of a conventional metal mold by the lithography has reached a practical level in terms of the technical aspect. Therefore, it is worth while manufacturing a conventional metal mold when the molded articles are to be manufactured in a large quantity. However, it has been unprofitable in terms of cost when the molded articles are manufactured in a small quantity.

### [Patent Document 1]

Japanese Unexamined Patent Application Publication No. 2-297409

### [Patent Document 2]

Japanese Unexamined Patent Application Publication No. 10-50576

### Disclosure of the Invention

### Technical Problems

As described above, a conventional lithography process involves many manufacturing processes. Therefore, manufacturing of a conventional metal mold is not only very expensive, but also takes a long time.

The present invention has been made to solve these problems in optical molding, and an object of the present invention is to provide a metal mold for micro components at low cost in a short time by using an optically molded object formed by an optical molding method.

### Technical Solution

A method of manufacturing a mold for molding in accordance with the present invention includes: repeating application of a photo-curable liquid resin composition to form a photo-curable liquid composition layer and irradiation of the formed photo-curable liquid composition layer with light; forming a three-dimensional object by removing a non-cured portion from the laminated body of the photo-curable liquid resin composition layers; and forming the mold for molding based on the three-dimensional molded object; the method further including: forming a metal coating covering the three-dimensional molded object; removing the three-dimensional molded object covered with the metal coating; and taking the metal coating as the mold for molding. As described above, a mold for molding is manufactured by using an optically molded object formed by a micro optical molding method, i.e., by using a three-dimensional molded object in the present invention. Furthermore, it is preferable that a three-dimensional molded object contains an alkali-soluble resin so that the removal of the three-dimensional molded object covered with the metal coating is carried out with an alkaline solution. Furthermore, the formation of the metal coating is preferably carried out by forming a primary film on the surface of the three-dimensional molded object and then forming a metal film on the primary film by an electroplating method. The manufacturing of a molded article in which the molded article is manufactured by using a mold for molding is preferably performed by filling the mold for molding with resin, separating the resin from the mold for molding, and taking the resin as the molded article.

### Advantageous Effects

A method of manufacturing a mold for molding and a method of manufacturing a molded article in accordance with the present invention enables to provide a metal mold for a micro component at low cost in a short time.

### Brief Description of the Drawings

Fig. 1 shows a schematic structure of an optical molding apparatus in accordance with an embodiment of the present invention;
Fig. 2A shows a method of manufacturing a metal mold in accordance with an embodiment of the present invention;
Fig. 2B shows a method of manufacturing a metal mold in accordance with an embodiment of the present invention;
Fig. 2C shows a method of manufacturing a metal mold in accordance with an embodiment of the present invention;
Fig. 2D shows a method of manufacturing a metal mold in accordance with an embodiment of the present invention;
Fig. 3A shows a method of forming a conventional metal mold using a lithography technique in the related art;
Fig. 3B shows a method of forming a conventional metal mold using a lithography technique in the related art;
Fig. 3C shows a method of forming a conventional metal mold using a lithography technique in the related art; and
Fig. 3D shows a method of forming a conventional metal mold using a lithography technique in the related art.

### Explanation of Reference

- 1: light source
- 2: DMD
- 3: lens
- 4: base material
- 5: dispenser
- 6: recoater
- 7: control portion
- 8: storage portion
- 9: photo-curable liquid resin composition
- 10: three-dimensional molded object
- 11: primary film
- 12: metal film
- 13: micro mold
- 100: optical molding apparatus

### Best Modes for Carrying Out the Invention

A method of manufacturing a mold for molding in accordance with the present invention is explained hereinafter. Firstly, a three-dimensional molded object is formed. The three-dimensional molded object has an inverted shape of a mold for molding, and is used to transfer a pattern on the mold for molding. Firstly, a photo-curable liquid resin layer is formed by applying a photo-curable liquid resin composition. Note that the detail of the photo-curable liquid resin composition is explained later. Then, a portion of this photo-curable liquid resin composition layer is cured by irradiating it with light. In this example, one-shot exposure is performed repeatedly for each fixed area (hereinafter called "projection area"), for example, by using a digital mirror device (DMD). Then, light is selectively radiated within the projection area, so that only an arbitrarily-selected area of the photo-curable liquid resin composition layer is cured. In this example, light is radiated using a projection area equal to or less than 100 mm² as a unit. In this way, a portion irradiated with light is exposed with the light and cured, so that a first cured resin layer is formed. Similarly, a second cured resin layer is formed on the first cured resin layer, and cured resin layers are laminated one after another. Then, unexposed portions are removed by cleaning or other methods. In this way, a three-dimensional molded object is formed.

Firstly, the above-mentioned photo-curable liquid resin composition is explained hereinafter.

### [I. Photo-curable liquid resin composition]

A photo-curable liquid resin composition in accordance with the present invention contains, as essential components, (A) a copolymer having alkali solubility having (a) a structural unit derived from a polymerizable compound having a carboxyl group, (b) a structural unit derived from a polymerizable compound having a phenolic hydroxyl group, and (c) a structural unit derived from other polymerizable compounds, (B) a compound having at least one ethylenic unsaturated double bond, and (C) a radiation radical polymeric initiator. Furthermore, (D) an organic solvent and other additive agents may be mixed as nonessential components.

### (A) Alkali-soluble copolymer

(A) component used in the present invention is a copolymer having alkali solubility (hereinafter called "alkali-soluble copolymer (A)"), and can be obtained by radical-copolymerizing, in a solvent, (a') a radical polymerizable compound having a carboxyl group in an amount of typically 1 to 50 mass%, preferably 5 to 40 mass%, and especially preferably 10 to 30 mass%, (b') a radical polymerizable compound having a phenolic hydroxyl group in an amount of typically 1 to 50 mass%, preferably 5 to 40 mass%, and especially preferably 10 to 30 mass%, and (c') other radical polymerizable compounds in an amount of typically 5 to 80 mass%, preferably 20 to 70 mass%, and especially preferably 30 to 60 mass%. The structural unit (a), the structural unit (b), and the structural unit (c) are derived from a radical polymerizable compound (a'), a radical polymerizable compound (b'), and a radical polymerizable compound (c') respectively.

### (a') Radical polymerizable compound having a carboxyl group

The radical polymerizable compound having a carboxyl group (hereinafter called "carboxyl group compound (a')"), i.e. , (a') component adjusts the alkali solubility of alkali-soluble copolymer (A). For example, monocarboxylic acid such as acrylic acid, methacrylic acid, crotonic acid, 2-succinoloylethyl (meth)acrylate, 2-maleinoloylethyl (meth)acrylate, 2-hexahydrophthaloylethyl (meth)acrylate, ω-carboxy-polycaprolactone monoacrylate (e.g., Aronix M-5300 from Toagosei Co., Ltd. as a commercially-available product), phthalic acid monohydroxyethyl acrylate (e.g., Aronix M-5400 from the same company as a commercially-available product), and acrylic acid dimer (e.g., Aronix M-5600 from the same company as a commercially-available product); a (meth)acrylic acid derivative having a carboxyl group such as dicarboxylic acid such as maleic acid, fumaric acid, citraconic acid, mesaconic acid, and itaconic acid; and the like can be used for it. These compounds may be used either individually or in combination of two or more. Among these compounds, acrylic acid, methacrylic acid, and 2-hexahydrophthaloylethyl methacrylate are preferred. These compounds may be used either individually or in combination of two or more.

The structural unit (a) derived from a carboxyl group compound (a') is contained in the alkali-soluble copolymer (A) obtained by the above-mentioned method, typically in 1 to 50 mass%, preferably in 3 to 40 mass%, and especially preferably in 5 to 30 mass%. Too little structural units lead to insufficient solubility to a copolymer alkaline aqueous solution, and thus making the removal of non-cured portions from the three-dimensional structure by an alkaline aqueous solution very difficult. Therefore, it could become impossible to obtain sufficient resolution. On the other hand, too many structural units make the solubility to the copolymer alkaline aqueous solution too high, and therefore it could lead to unnecessarily large dissolution of the exposed portions, i.e., unnecessarily large film removal.

### (b') Radical polymerizable compound having a phenolic hydroxyl group

Examples of the radical polymerizable compound having a phenolic hydroxyl group (hereinafter called "phenolic hydroxyl group compound (b')"), i.e., (b') component may include p-hydroxystyrene, m-hydroxystyrene, o-hydroxystyrene, α-methyl-p-hydroxystyrene, α-methyl-m-hydroxystyrene, α-methyl-o-hydroxystyrene, 2-allylphenol, 4-allylphenol, 2-allyl-6-methylphenol, 2-allyl-6-methoxyphenol, 4-allyl-2-methoxyphenol, 4-allyl-2,6-dimethylphenol, and 4-allyloxy-2-hydroxybenzophenone. Among these compounds, p-hydroxystyrene or α-methyl-p-hydroxystyrene is preferred. These compounds may be used either individually or in combination of two or more.

The structural unit derived from a compound having a phenolic hydroxyl group (b') is contained in the alkali-soluble copolymer (A), typically in 1 to 50 mass%, and preferably in 5 to 40 mass%. Too little structural units decrease the resolution of the photo-curable liquid resin composition. On the other hand, too many structural units hinder the acquisition of copolymers having sufficiently large molecular weight, and thus making the formation of coating having a film-thickness of 20 µm or greater very difficult.

Furthermore, a precursor of a phenolic hydroxyl group compound (b') protected by a functional group that can be converted into a phenolic hydroxyl group after the copolymer having alkali solubility is synthesized can be used as the phenolic hydroxyl group compound (b'). Substances such as p-acetoxystyrene, α-methyl-p-acetoxystyrene, p-benzyloxystyrene, p-tert-butoxystyrene, p-tert-butoxycarbonyloxystyrene, and p-tert-butyldimethylsiloxystyrene can be used as the precursor. A copolymer obtained by using these substances can be easily converted into a structural unit derived from a phenolic hydroxyl group compound (b') by an appropriate process, e.g., hydrolysis using hydrochloric acid or the like.

### (c') Other radical polymerizable compounds

The other radical polymerizable compounds (hereinafter called "other radical compounds (c')") i.e., (c') components are used mainly for the purpose of appropriately controlling the mechanical characteristics of alkali-soluble copolymer (A). Note that the term "other" is used to express radical polymerizable compounds other than the aforementioned radical polymerizable compound (a') component and (b') component. These other radical polymerizable compounds (c') may include (meth) acrylic acid alkyl esters, (meth) acrylic acid aryl esters, dicarboxylic acid diesters, a polymerizable compound containing a nitrile group, a polymerizable compound containing an amide bond, fatty acid vinyls, a polymerizable compound containing chlorine, and conjugated diolefin. Specifically, (meth) acrylic acid alkyl esters such as methyl (meth) acrylate, ethyl (meth)acrylate, n-butyl (meth)acrylate, sec-butyl (meth)acrylate, tert-butyl (meth)acrylate, isopropyl (meth)acrylate, n-hexyl (meth)acrylate, cyclohexyl (meth)acrylate, 2-methylcyclohexyl (meth)acrylate, dicyclopentanyloxyethyl (meth)acrylate, isobornyl (meth)acrylate, dicyclopentanyl (meth)acrylate, methoxydipropylene glycol (meth)acrylate, butoxy-dipropylene glycol (meth)acrylate, methoxydipropylene glycol (meth)acrylate, and methoxypropylene glycol (meth)acrylate; dicarboxylic acid diesters such as diethyl maleate, diethyl fumarate, and diethyl itaconate; (meth) acrylic acid aryl esters such as phenyl (meth)acrylate and benzyl (meth)acrylate; aromatic vinyls such as styrene, α-methylstyrene, m-methylstyrene, p-methylstyrene, vinyltoluene, and p-methoxy styrene; polymerizable compounds containing nitrile groups such as acrylonitrile and methacrylonitrile; polymerizable compounds containing amide bonds such as acrylamide and methacrylamide; fatty acid vinyls such as vinyl acetate; polymerizable compounds containing chlorine such as vinyl chloride and vinylidene chloride; and conjugated diolefins such as 1,3-butadiene, isoprene, and 1,4-dimethylbutadiene can be used. These compounds may be used either individually or in combination of two or more.

The structural unit (c) derived from other radical polymerizable compounds (c') is contained in the alkali-soluble copolymer (A), typically in 5 to 80 mass%, preferably in 20 to 70 mass%, and especially preferably in 30 to 60 mass%.

Preferable polymer solvents used in the production of an alkali-soluble copolymer (A) include cyclic ethers, alkyl ethers of polyhydric alcohol, alkyl ether acetates of polyhydric alcohol, ketones, esters, and the likes.

Furthermore, a typical radical polymeric initiator can be used as a polymerization catalyst in the radical-copolymerizing, and its examples may include azo compounds such as 2,2'-azobisisobutyronitrile, 2,2'-azobis-(2,4-dimethylvaleronitrile), and 2,2'-azobis-(4-methoxy-2-dimethylvaleronitrile); organic peroxides such as benzoyl peroxide, lauroyl peroxide, tert-butylperoxy pivalate, and 1'-bis-(tert-butylperoxy)cyclohexane; and hydrogen peroxide. In a case where peroxide is used as a radical polymeric initiator, it may be used as a redox-type initiator by combining it with a reducing agent.

Resin in a range between 3,000 and 30,000, preferably between 5, 000 and 25, 000, and more preferably between 7, 000 and 20,000 in weight-average molecular weight Mw in terms of polystyrene by gel-permeation chromatography may be used as the resin component (alkali-soluble copolymer (A)). Weight-average molecular weight less than 3,000 could hinder the formation of coating after the removal of the solvent, and weight-average molecular weight greater than 30,000 could make the removal of non-cured portions at the time when the three-dimensional molded object is taken out and the removal of the three-dimensional molded object from the mold for molding explained later very difficult.

The amount of the alkali-soluble copolymer (A) is 25 to 60 mass% when the total amount of the composition excluding the organic solvent (D) is defined as 100 mass%. Within this limit, it is possible to keep the viscosity of the composition low regardless of the mixture amount of the organic solvent (D) by changing the mixture amount of the (A) component according to the amount of the organic solvent (D) mixed in the composition, so that the coating film of resin liquid can be easily formed when it is applied to a microscopic molding method. When the mixture amount of the organic solvent (D) is no less than 0 pts.mass and less than 20 pts.mass when the total amount of the composition excluding the organic solvent (D) is defined as 100 pts.mass, the mixture amount of the alkali-soluble copolymer (A) is preferably 25 to 55 mass%, more preferably 25 to 45 mass%, and especially preferably 30 to 40 mass% when the total amount of the composition excluding the organic solvent (D) is defined as 100 mass%. When the mixture amount of the organic solvent (D) is no less than 20 pts.mass and no greater than 200 pts.mass when the total amount of the composition excluding the organic solvent (D) is defined as 100 pts.mass, the mixture amount of the alkali-soluble copolymer (A) is preferably 40 to 60 mass%, and especially preferably 45 to 55 mass% when the total amount of the composition excluding the organic solvent (D) is defined as 100 mass%.

### (B) Compound having at least one ethylenic unsaturated double bond

A compound having at least one ethylenic unsaturated double bond (hereinafter called "ethylenic unsaturated compound (B)") that is used as (B) component in the present invention is a compound that has at least one ethylenic unsaturated group in its molecule and is in a liquid or solid state at a room temperature. Typically, a (meth)acrylate compound having a (meth)acryloyl group as the ethylenic unsaturated group or a compound having a vinyl group as the ethylenic unsaturated group is used as the ethylenic unsaturated compound (B). Either of a mono-functional compound (compound having one (meth) acryloyl group) and a poly-functional compound (compound having more than one (meth) acryloyl group) can be used as the (meth)acrylate compound.

A commercially-available compound may be used as ethylenic unsaturated compound (B) without requiring any additional process. Specific examples of commercially-available compounds include Aronix M-210, M-309, M-310, M-400, M-7100, M-8030, M-8060, M-8100, M-9050, M-240, M-245, M-6100, M-6200, M-6250, M-6300, M-6400, and M-6500 (all available from Toagosei Co., Ltd.), KAYARAD R-551, R-712, TMPTA, HDDA, TPGDA, PEG400DA, MANDA, HX-220, HX-620, R-604, DPCA-20, DPCA-30, DPCA-60, and DPCA-120 (all available from Nippon Kayaku Co., Ltd.), and Viscoat #295, #300, #260, #312, #335HP, #360, #GPT, #3PA, and #400 (all available from Osaka Organic Chemical Industry Ltd.). These ethylenic unsaturated compounds (B) may be used either individually or in combination of two or more.

The amount of the ethylenic unsaturated compound (B) is 35 to 70 mass% when the total amount of the composition excluding the organic solvent (D) is defined as 100 mass%. When the mixture amount of the organic solvent (D) is no less than 0 pts.mass and less than 20 pts.mass when the total amount of the composition excluding the organic solvent (D) is defined as 100 pts.mass, the mixture amount of the ethylenic unsaturated compound (B) is preferably 35 to 70 mass%, and more preferably 35 to 65 mass% when the total amount of the composition excluding the organic solvent (D) is defined as 100 mass%. When the mixture amount of the organic solvent (D) is no less than 20 pts.mass and no greater than 200 pts.mass when the total amount of the composition excluding the organic solvent (D) is defined as 100 pts.mass, the mixture amount of the ethylenic unsaturated compound (B) is preferably 35 to 55 mass%, and especially preferably 40 to 50 mass% when the total amount of the composition excluding the organic solvent (D) is defined as 100 mass%. When the mixture amount of (B) component is less than the above-mentioned lower limit value, the photo-curing ability tends to be lowered. When it is larger than the upper limit value, the compatibility with the copolymer (A) deteriorates, so that the preservation stability could be lowered and the formation of thick film having a film-thickness of 20 µm or greater as a single cured resin layer very difficult.

### (C) Radiation radical polymeric initiator

Examples of the radiation radical polymeric initiator (hereinafter called "radiation radical polymeric initiator (C)") that is used as (C) component in the present invention include α-diketones such as benzil and diacetyl; acyloins such as benzoin; acyloin ethers such as benzoin methyl ether, benzoin ethyl ether, and benzoin isopropyl ether; benzophenones such as thioxanthone, 2,4-diethylthioxanthone, thioxanthone-4-sulfonic acid, benzophenone, 4,4'-bis(dimethylamino)benzophenone, and 4,4'-bis(diethylamino)benzophenone; acetophenones such as acetophenone, p-dimethylaminoacetophenone, α,α-dimethoxy-α-acetoxybenzophenone, α,α-dimethoxy-α-phenylacetophenone, p-methoxyacetophenone, 1-[2-methyl-4-methylthiophenyl]-2-morphorino-1-propanone, α,α-dimethoxy-α-morphorino-methylthiophenyl acetophenone, and 2-benzyl-2-dimethylamino-1-(4-morphorinophenyl)-butane-1-on e; quinones such as anthraquinone and 1,4-naphthoquinone; halides such as phenacyl chloride, tribromomethyl phenylsulfone, and tris(trichloromethyl)-s-triazine; bisimidazoles such as [1,2'-bisimidazole]-3,3'4,4'-tetraphenyl and [1,2'-bisimidazole]-1,2'-dichlorophenyl-3,3'4,4'-tetrapheny 1; peroxides such as di-tert-butyl peroxide; and acylphosphine oxides such as 2,4,6-trimethyl benzoyl diphenylphosphine oxide. Examples of commercially-available products includes Irgacure 184, 651, 500, 907, CGI369, and CG24-61 (all available from Ciba Specialty Chemicals Inc.), Lucirin LR8728 and Lucirin TPO (all available from BASF Co.), Darocur 1116 and 1173 (all available from Ciba Specialty Chemicals Inc.), and Uvecryl P36 (available from UCB Co.). Furthermore, if necessary, a compound having a hydrogen donating property, such as mercaptobenzothiazole and mercaptobenzoxazole may be used in combination with the above-mentioned radiation radical polymeric initiator.

Among the above-mentioned various radiation radical polymeric initiators, preferable initiators may include acetophenones such as 1-[2-methyl-4-methylthiophenyl]-2-morphorino-1-propanone, 2-benzyl-2-dimethylamino-1-(4-morphorinophenyl)-butane-1-on e, and α,α-dimethoxy-α-phenylacetophenone, phenacyl chloride, tribromomethyl phenylsulfone, 2,4,6-trimethyl benzoyl diphenylphosphine oxide, a combination of 1,2'-bisimidazoles, 4,4'-diethylaminobenzophenone, and mercaptobenzothiazole, Lucirin TPO, and Irgacure 651. These compounds may be used either individually or in combination of two or more.

The mixture amount of the radiation radical polymeric initiator (C) is preferably 0.1 to 10 mass%, more preferably 0.5 to 7 mass%, and especially preferably 1 to 7 mass% when the total amount of the composition excluding the organic solvent (D) is defined as 100 mass%. When the mixture amount of (C) component is less than 0.1 mass%, it could be subject to the influence of the deactivation of radical by oxygen (decrease of sensitivity). On the other hand, when it exceeds 10 mass%, there is a tendency that the compatibility deteriorates and the preservation stability decreases. It is also possible to use these radiation radical polymeric initiators in combination with a radiosensitizing agent.

### Other components

In the present invention, it is possible, if necessary, to use an organic solvent (D) and components such as various additives in addition to the above-described alkali-soluble copolymer (A), the ethylenic unsaturated compound (B), and the radiation radical polymeric initiator (C).

An organic solvent that can dissolve alkali-soluble copolymer (A) and the other components uniformly and does not react to any of these other components may be used as the organic solvent (D). A solvent similar to the polymerizing solvent used to produce the alkali-soluble copolymer (A) may be used as the organic solvent.

In terms of solubility, reactivity to each component, and easiness of coating-film formation, alkyl ethers of polyhydric alcohol such as ethylene glycol monoethyl ether and diethylene glycol monomethyl ether; alkyl ether acetates of polyhydric alcohol such as ethyl cellosolve acetate and propylene glycol monomethyl ether acetate; esters such as ethyl 3-ethoxypropionate, methyl 3-methoxypropionate, and ethyl 2-hydroxypropionate; and ketones such as diacetone alcohol are preferred as these organic solvents (D).

The amount of the organic solvent (D) is 0 to 200 pts.mass when the total amount of the composition excluding the organic solvent (D) is defined as 100 pts.mass. As described above, the ranges of the mixture amounts of the component (A) and the component (B) are different between a case where the organic solvent (D) is not contained or the mixture amount is less than 20 pts.mass and a case where the mixture amount of the organic solvent (D) is no less than 20 pts.mass and no greater than 200 pts.mass.

A thermal polymerization prohibiting agent can be added to a photo-curable liquid resin composition in accordance with the present invention. Such thermal polymerization prohibiting agents may include pyrogallol, benzoquinone, hydroquinone, methylene blue, tert-butylcatechol, monobenzyl ether, methylhydroquinone, amylquinone, amyloxyhydroquinone, n-butylphenol, and phenol. These compounds are preferably used in an amount of no more than 5 pts.mass to the alkali-soluble copolymer (A) of 100 pts.mass.

A surfactant may be also mixed to a photo-curable liquid resin composition in accordance with the present invention for the purpose of improving an application property, a defoaming property, a leveling property, and the like. For example, fluorochemical surfactants like the ones commercially available under the trade names of BM-1000 and BM-1100 (all available from BM Chemy Co.), Megafac F142D, F172, F173, and F183, R-08 (all available from DIC corporation), Fluorad FC-135, FC-170C, FC-430, and FC-431 (all available from Sumitomo 3M Limited), Surflon S-112, S-113, S-131, S-141, and S-145 (all available from Asahi Glass Co., Ltd.), and SH-28PA, SH-190, SH-193, SZ-6032, and SF-8428 (all available from Dow Corning Toray Silicone Co., Ltd.) can be used. The mixture amount of these surfactants is preferably no more than 5 pts.mass to the alkali-soluble copolymer (A) of 100 pts.mass.

An adhesion assisting agent may be used in the photo-curable liquid resin composition in accordance with the present invention to improve adhesion to the substrate. As the adhesion assisting agent, a functional silane coupling agent is effective. Note that the functional silane coupling agent means a silane coupling agent having a reactive substituent such as a carboxyl group, a methacryloyl group, an isocyanate group, and an epoxy group. Specific examples of such functional silane coupling agents include trimethoxysilylbenzoic acid, γ-methacryloxypropyltrimethoxysilane, vinyltriacetoxysilane, vinyltrimethoxysilane, γ-isocyanatopropyltriethoxysilane, γ-glycidoxypropyltrimethoxysilane, and β-(3,4-epoxycyclohexyl)ethyltrimethoxysilane. Its mixture amount is preferably equal to or less than 20 pts.mass per 100 pts.mass of the alkali-soluble copolymer (A).

Furthermore, if necessary, filler, a coloring agent, a viscosity modifier, and the like can be added to the photo-curable liquid resin composition in accordance with the present invention. Examples of the fillers include silica, alumina, talc, bentonite, zirconium silicate, and powder glass. Examples of the coloring agents include extenders such as alumina white, clay, barium carbonate, and barium sulfate; inorganic pigments such as zinc white, white lead, yellow lead, red lead, ultramarine, iron blue, titanium oxide, iron red, and carbon black; organic pigments such as brilliant carmine 6B, permanent red 6B, permanent red R, benzidine yellow, phthalocyanine blue, and phthalocyanine green; basic dyes such as magenta and rhodamine; direct dyes such as direct scarlet and direct orange; and acid dyes such as roselyn and metanil yellow. Furthermore, examples of the viscosity modifiers include bentonite, silica gel, and aluminum powder. The mixture amounts of these additives should be within the limits in which the essential characteristics of the composition are not impaired, and they are preferably equal to or less than 50 pts.mass to the composition to be obtained.

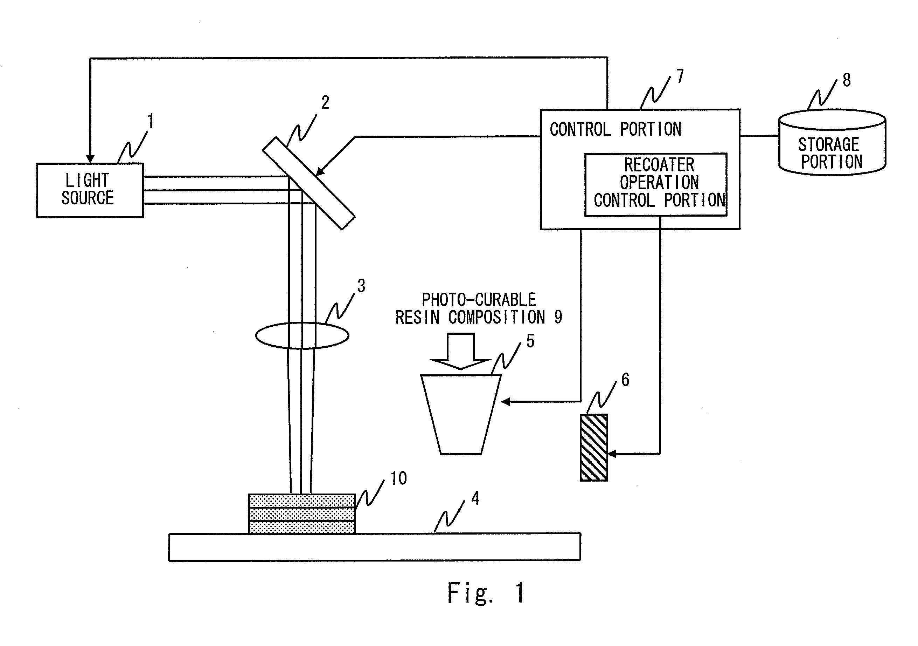

Next, a method of manufacturing a three-dimensional molded object 10 by an optical molding apparatus 100 is explained hereinafter with reference to Fig. 1. Fig. 1 shows a schematic structure of an optical molding apparatus in accordance with an embodiment of the present invention. As shown in Fig. 1, the optical molding apparatus for forming a three-dimensional molded object 10 includes a light source 1, a DMD 2, a lens 3, base material 4, a dispenser 5, a recoater 6, a control portion 7, and a storage portion 8.

Firstly, a photo-curable liquid resin composition 9 in a non-cured state is put in the dispenser 5. The base material 4, which is composed of a wafer or the like, is positioned at the initial position. The base material 4 is a plate-shaped pedestal on which cured resin is successively deposited and placed. The dispenser 5 supplies a prescribed amount of the contained photo-curable liquid resin composition 9 to a predefined place on the base material 4. The recoater 6 includes, for example, blade mechanism and moving mechanism. The recoater 6 sweeps the photo-curable liquid resin composition 9 such that the photo-curable liquid resin composition 9 is uniformly drawn out, and forms a coating layer corresponding to one layer to be cured.

If the photo-curable liquid resin composition 9 contains an organic solvent, the film contains a larger quantity of the organic solvent immediately after the application. Therefore, it is also possible to carry out heating to remove the solvent. When the heating is carried out, for example, a hotplate, an oven, an infrared heater, or the like can be used. Furthermore, although the heating condition depends on the type of solvent and the film thickness of coating, it may be carried out, for example, at 40 to 150°C for one minute. As described above, when heating is carried out, the organic solvent of the coating film does not necessarily have to be completely removed. That is, it does not pose any problem even if the solvent remains in the coating film, for example, by several mass%. A process to form a three-dimensional molded object 10 by irradiating a photo-curable liquid resin composition layer 9B, from which the organic solvent is removed, with light is explained hereinafter.

A light beam emitted from the light source 1 enters to the DMD 2. The light source 1 generates a light beam such as a laser beam. For example, a laser diode (LD) capable of generating a laser beam of 405 nm, or an ultraviolet (UV) lamp may be used as the light source 1. The type of the light source 1 is selected based on the relation with the curing wavelength of a photo-curable liquid resin composition, and the optical molding method in accordance with the present invention is not limited to a certain type of light source 1.

The DMD 2 has a CMOS (Complementary Metal Oxide Semiconductor) semiconductor covered with a lot of micro mirrors, each of which is independently movable. The micro mirror is a device capable of inclining around the diagonal line by a certain angle by an electrostatic field effect. For example, a device available from Texas Instruments Incorporated or the like can be used as the DMD 2. The DMD 2 used in this embodiment has a rectangular shape of 40.8×31.8 mm as a whole (while the mirror portion has a rectangular shape of 14.0×10.5 mm), and composed of 786,432 micro mirrors of 13.68 µm on each side arranged at intervals of 1 µm. Furthermore, the micro mirror can be inclined around the diagonal line by about ±10 degrees, e.g., by ±12 degrees. The DMD 2 reflects light beams emitted from the light source 1 by the individual micro mirrors such that only the light beams that are reflected on the micro mirrors controlled to a predefined angle by the control portion 7 are radiated to the photo-curable liquid resin composition layer 9B located on the base material 4 through the lens 3.

The unit area in which the light beam reflected by the DMD 2 is radiated on the photo-curable liquid resin composition layer 9B through the lens 3 at a time is called "projection area". By controlling the angles of the micro mirrors individually and determining whether or not the reflected light beam is radiated to the photo-curable liquid resin composition layer 9B for each micro mirror, a pattern in which the light is selectively radiated is determined within the projection area.

Specifically, the DMD 2 is controlled by the control portion 7, and adjusts the angles of part of the micro mirrors that corresponds to the portion where the photo-curable liquid resin composition layer 9B is irradiated with the light beam (three-dimensionally shaped object and projection shape object having desired shapes). In this way, the light beams that are reflected on that part of the micro mirrors are radiated to the photo-curable liquid resin composition layer 9B through the lens 3, and the light beams that are reflected on the other micro mirrors are not radiated to the photo-curable liquid resin composition layer 9B. The amount of the light beam to the photo-curable liquid resin composition layer 9B may be adjusted as appropriate so that an optimal curing property is achieved depending on the type of photo-curable liquid resin composition. Note that although the projection area to the photo-curable liquid resin composition layer 9B is a factor that depends on the number of mirrors in the DMD 2, the size of each mirror, the type of the lens 3, and the projection magnification, it can be changed as appropriate by adopting a proper projection magnification according to the required resolution for the three-dimensionally shaped object. The lens 3 in accordance with this embodiment is a condensing lens, and reduces the incident light by about 15-fold and concentrates the light on the photo-curable liquid resin composition layer 9B.

Furthermore, it is also possible to magnify the projection area to an area larger than the actual size of the DMD 2 by using a concave lens as the lens 3. Since the magnification of the projection area weakens the intensity of the light beam, the preferable size of the projection area is typically equal to or less than 100 mm². Furthermore, in a case where a three-dimensional molded object larger than the size of projection area of the light beam is to be formed, it is necessary to move the irradiating place of the light beam, for example, by horizontally or vertically moving the base material 4 with driving mechanism, i.e., moving mechanism (not shown) so that the entire molding area is irradiated. In this case, the irradiation with the light beam is performed on a one-shot basis for each of the projection areas.

By moving the projection area and carrying out irradiation with a light beam, i.e., exposure by defining each projection area as a unit in a manner like this, the photo-curable liquid resin composition layer 9B is cured and the first cured resin layer is formed. The lamination pitch corresponding to one layer, i.e., the thickness of one cured resin layer is, for example, 1 to 50 µm, preferably 2 to 10 µm, and more preferably 5 to 10 µm.

The above-mentioned light source 1, the DMD 2, the base material 4, the dispenser 5, and the recoater 6 are controlled by the control portion 7. The control portion 7 controls these components according to control data including exposure data. The control portion 7 can be typically constructed by installing a certain program in the computer. A typical computer configuration includes a central processing unit (CPU) and a memory. The CPU and memory are connected to an external storage device such as a hard disk drive that serves as an auxiliary storage device through a bus. This external storage device functions as the storage potion 8 of the control portion 7. A transportable storage medium such as a flexible disk is inserted to the storage medium drive device that functions as the storage portion 8, such as a flexible disk drive, a hard disk drive, or a CD-ROM drive. Certain computer programs that cooperate with the operating system to give instructions to the CPU for carrying out this embodiment can be stored in the storage medium.

The storage portion 8 stores control data including exposure data for a group of cross sections that are obtained by slicing a three-dimensional molded object 10 to be molded into a plurality of layers. The control portion 7 carries out the molding of a three-dimensional molded object 10 by controlling mainly the angle of each micro mirror in the DMD 2 and the movement of the base material 4 (i.e., the place of the light beam irradiation area for the three-dimensional molded object 10) based on the exposure data stored in the storage portion 8.

Computer programs are loaded to the memory to be executed. The computer programs can be compressed or divided into a plurality of pieces to be stored in a storage medium.
Furthermore, user interface hardware can be provided. The user interface hardware may include, for example, a pointing device for input such as a mouse, a keyboard, and a display device for presenting visual data to a user.

Subsequently, the second layer of the three-dimensional molded object 10 is formed in a desired shape by a similar process at the same time. Specifically, the photo-curable liquid resin composition 9 supplied from the dispenser 5 is applied on the cured resin layer that was formed as the first layer such that the photo-curable resin composition 9 is drawn out beyond the three-dimensional molded object in a uniform thickness by the recoater 6. Then, the second cured resin layer is formed on the first cured resin layer by irradiating it with a light beam. The third and subsequent cured resin layers are successively stacked in a similar manner. Then, after the stacking of the final layer is completed, the three-dimensional molded object 10 formed on the base material 4 is taken out. A photo-curable liquid resin composition that is adhered on the surface of the three-dimensional molded object 10 is removed by cleaning or other process. If necessary, the curing may be further advanced by irradiating the three-dimensional molded object 10 with an ultraviolet lamp or the like, or by heating the three-dimensional molded object 10. Although a molding method by an optical molding apparatus using a DMD has been explained in the above explanation, other molding methods may be also applied provided that the molding method can achieve preferable resolving power of 20 µm or smaller.

With regard to the method of removing a non-cured portion from a three-dimensional molded object 10 generated in the manner described above, a method in which an unnecessary unexposed portion is dissolved and removed by using an organic solvent or an alkaline aqueous solution and only the exposed portion is left intact so that a cured film having a desired pattern is obtained is preferred. Cyclic ethers, alkyl ethers of polyhydric alcohol, alkyl ether acetates of polyhydric alcohol, ketones, esters, and the likes may be used as the organic solvent.

Furthermore, for example, an aqueous solution of alkalis such as sodium hydroxide, potassium hydroxide, sodium carbonate, sodium silicate, sodium metasilicate, ammonia water, ethylamine, n-propylamine, diethylamine, di-n-propylamine, triethylamine, methyl diethylamine, dimethyl ethanolamine, triethanolamine, tetramethylammonium hydroxide, tetraethylammonium hydroxide, choline, pyrrole, piperidine, 1,8-diazabicyclo[5.4.0]-7-undecene, 1,5-diazabicyclo[4.3.0]-5-nonane, and the like can be used as the alkaline aqueous solution. Furthermore, an aqueous solution generated by adding a proper amount of a water-soluble organic solvent such as methanol and ethanol or a surfactant to the above-mentioned aqueous solutions of alkalis can be also used. To achieve molding with high precision, the removal of a non-cured portion is preferably carried out with an alkaline aqueous solution.

As described above, a three-dimensional molded object 10 having a desired shape is molded by using the optical molding apparatus 100 and by using the photo-curable liquid resin composition 9. Since the solvent is removed from the photo-curable liquid resin composition 9 in this embodiment of the present invention, the fluidity in each layer is suppressed. Therefore, it is not necessary to form the support, and thus enabling molding with high precision. Note that the non-cured potion can be removed by a solvent or the like after the molding is completed.

Next, a metal coating covering a three-dimensional molded object 10 formed in the manner described above is formed. That is, a metal coating is formed along the shape of the three-dimensional molded object 10. In this way, the shape of the three-dimensional molded object 10 is transferred to the metal coating. Then, an inverted shape of the three-dimensional molded object 10 is formed on the metal coating. After that, the three-dimensional molded object 10 covered with the metal coating is removed. In this way, a metal mold formed from the metal coating becomes a mold for molding.

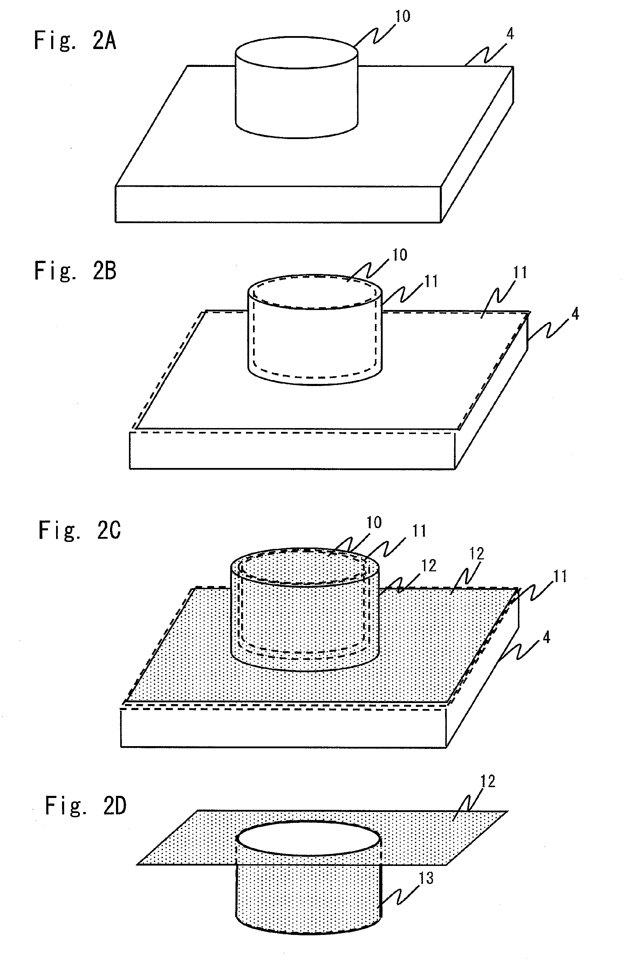

A method of manufacturing a micro mold as a mold for molding by using a three-dimensional molded object 10 in accordance with this embodiment of the present invention is explained hereinafter with reference to Figs. 2A to 2D. Figs. 2A to 2D show a method of manufacturing a micro mold 13.

Firstly, a three-dimensional molded object 10 is formed on the base material 4 in the manner described above. Furthermore, any photo-curable liquid resin composition that is adhered on the surface of the three-dimensional molded object 10 is removed by cleaning or other process. This cleaned three-dimensional molded object 10 serves as a master model. In this manner, it becomes a structure shown in Fig. 2A.

Next, a primary film 11 that is used to perform a plating process in a later process is formed on the surface of the three-dimensional molded object 10 as shown in Fig. 2B. The primary film 11 can be formed by using a sputter method. This primary film 11 can serve as a conductive metal coating, and is, for example, composed of metal such as copper.

As shown in Fig. 2C, the three-dimensional molded object 10 coated with the primary film 11 is put in an electroforming liquid, and a plating process is performed on the three-dimensional molded object 10 by feeding electricity through the metal such as copper. Nickel sulfamate can be used as an example of this electroforming liquid. The current density with which the plating is carried out is, for example, 2 to 6 A/dm², and the plating time can be adjusted as appropriate based on the thickness of the metal coating. A metal film 12 is formed on the primary film 11 by this plating process. That is, the metal film 12 is formed as a metal coating such that it covers the three-dimensional molded object 10.

After that, the base material 4 is taken out from the metal film 12, and the three-dimensional molded object 10 left in the metal film 12 is removed. Since a photo-curable liquid resin composition used in the present invention contains specific alkali-soluble resin, the three-dimensional molded object 10 left in the metal film 12 can be removed by dissolving the three-dimensional molded object 10 in an alkaline solution. A solution generated by dissolving organic alkali or inorganic alkali in an organic solvent can be used as the alkaline solution used for the removal of the three-dimensional molded object 10. Tetramethylammoniumhydroxide, choline, monoethanolamine, and the like can be used as the organic alkali used for the alkaline solution, and sodium hydroxide, potassium hydroxide, and the like can be used as the inorganic alkali used for the alkaline solution. Each of them may be used by dissolving it in an organic solvent such as dimethyl sulfoxide and N-methylpyrrolidone in an amount of 1 to 5 mass%.

As shown in Fig. 2D, the three-dimensional molded object 10 as well as the base material 4 is removed, so that only the metal film 12 is left. In this manner, the manufacturing of a micro mold 13 that serves as a mold for molding is completed. It is possible to form a small micro mold 13 to such an extent that the size of the generated micro mold 13, i.e., the diameter of the micro mold 13 can be as small as or smaller than 2 to 5 µm. Typically, a single or multiple shapes of a micro mold 13 exist in a metal mold of several centimeters square. A mold for molding is manufactured in the above described processes.

As described above, the three-dimensional molded object 10, which serves as the master model, is coated with the primary film 11 and the metal film 12 in this embodiment of the present invention. After that, the three-dimensional molded object 10 is separated or removed, so that only the metal film 12 is taken out as a micro mold 13. Since the three-dimensional molded object 10 is formed with high accuracy by the optical molding method, the micro mold 13, which is formed by using the three-dimensional molded object 10, can be also formed with high accuracy. Furthermore, it becomes possible to provide a metal mold for a micro component at low cost in a short time by manufacturing the mold for molding in the manner described above.

Furthermore, alkali-soluble resin is preferably contained in the ingredient for the three-dimensional molded object 10, so that the three-dimensional molded object 10 and the micro mold 13 can be separated with high accuracy. In this manner, since the three-dimensional molded object 10 and the micro mold 13 can be separated with high accuracy, the micro mold 13, which is formed by using the three-dimensional molded object 10, can be also formed with high accuracy.

A micro mold 13 formed in this manner may be used in the so-called nano-imprinting technology. Specifically, a heating process is firstly performed on resin to soften the resin. A micro mold 13 is filled with this softened resin by pressing the micro mold 13 on the resin. Then, the softened resin is thrust into depressions and projections carved on the micro mold 13. After that, the softened resin is cooled, and then the micro mold 13 and the resin are separated. In this way, since the shapes of depressions and projections on the micro mold 13 are transferred, inverted shapes of the depressions and projections of the micro mold 13 are formed on the resin. The resin on which these inverted shapes are formed becomes a molded article. In this manner, the molded article can be also formed with high accuracy by using the precise mold for molding. Furthermore, since a micro mold 13 can be provided at low cost in a short time, a molded article can be also provided at low cost in a short time.

### Mode for the Invention 1

Firstly, a method of preparing a photo-curable liquid resin composition 9, i.e., an ingredient of a three-dimensional molded object 10 in accordance with this embodiment of the present invention is explained hereinafter.

Firstly, after nitrogen-substitution was carried out in a flask having a dry-ice/methanol reflux device, 3.0 g of 2,2'-azobisisobutyronitrile and 100.0 g of ethyl 3-ethoxypropionate were fed as a polymeric initiator and an solvent respectively, and it was stirred until the polymeric initiator(2,2'-azobisisobutyronitrile) was dissolved. Next, after 35. 0 g of α-methyl-p-hydroxystyrene, 15. 0 g of methacrylic acid, and 50.0 g of n-butyl acrylate were fed, stirring was slowly started. Next, the temperature of the solution was raised to 80 °C, and polymerizing was carried out for seven hours at this temperature. After that, the reaction product was dropped into a large quantity of methanol so that the reaction product was coagulated. After this coagulant was washed with water, the coagulation was re-dissolved in tetrahydrofuran of the same mass and coagulated again in a large quantity of methanol. After repeating the re-dissolving and coagulating process for three times, the resultant coagulation was dried in vacuum at 40°C for 48 hours, and an alkali-soluble copolymer was obtained. The molecular weight (Mw) of this alkali-soluble copolymer was 11,000 as measured by gel-permeation chromatography.

Next, an alkali-soluble copolymer (37.1 pts.mass), ethoxylated trimethylolpropane triacrylate (7.8 pts.mass), N-vinyl-2-pyrrolidone (16.7 pts.mass), poly-functional acrylate (31.0 pts.mass), bis(2,4,6-trimethylbenzoyl)-phenylphosphine oxide (2.8 pts.mass), 2,4-diethylthioxanthone (1.9 pts.mass), 4-dimethylaminobenzoic acid ethyl ester (0.5 pts.mass), Yellow Gran 6G (coloring agent (1.9 pts.mass)), SH28PA: dimethylpolysiloxane polyoxyalkylene copolymer (surfactant (0.1 pts.mass)), and SH190: dimethylpolysiloxane polyoxyalkylene copolymer (surfactant (0.2 pts.mass)), and propylene glycol monomethyl ether acetate (PGMEA) (58.7 pts.mass) as a solvent were put in a vessel having a stirring device. Note that the bis(2,4,6-trimethylbenzoyl)-phenylphosphine oxide and the Yellow Gran 6G (coloring agent) were the ones from Ciba Specialty Chemicals Inc. Furthermore, SH28PA: dimethylpolysiloxane polyoxyalkylene copolymer (surfactant) and SH190: dimethylpolysiloxane polyoxyalkylene copolymer (surfactant) were the ones from Dow Corning Toray Co., ltd. Furthermore, the poly-functional acrylate (M8100) was the one from Toagosei Co., Ltd. Then, a photo-curable liquid resin composition 9 was prepared by stirring it at 25°C for 24 hours.

Then, a three-dimensional molded object 10 is formed on the base material 4 by the optical molding apparatus 100 by using a photo-curable liquid resin composition 9 formed in the manner described above. In this example, a silicon wafer was used as the base material 4. Next, a method of manufacturing a molded article in accordance with this embodiment of the present invention is explained hereinafter. Firstly, a primary film 11 was formed on the three-dimensional molded object 10 formed on the base material 4 by using copper, and a plating process was performed by using nickel sulfamate as the electroforming liquid. The plating was performed for six hours with the temperature of the plating bath being 45°C and the current density being 3A/dm². In this way, a nickel coating having a thickness of 800 µm was formed as the metal film 12 on the primary film 11.

After the metal film 12 was taken out from the base material 4, an alkaline peeling liquid (THB-S2 available from JSR Co., Ltd.) was used to remove the three-dimensional molded object 10 from the metal film 12. At this point, the temperature of the alkaline peeling liquid was adjusted to 60°C, and the liquid was stirred by a stirrer. After being submerged in the alkaline peeling liquid for ten minutes, washing with water was carried out for two minutes, and it was confirmed that residual resin on the three-dimensional molded object 10 was completely removed.

Furthermore, the transfer of the micro mold 13 formed in the manner described above was carried out to an arton base material available from JSR Co., Ltd. that was heated to 160°C. In this way, the formation of an inverted shape of the micro mold 13 was completed. By repeating the molding in this manner, it becomes possible to manufacture a molded article having the identical shape to the three-dimensional molded object 10 containing alkali-soluble resin.

### Industrial Applicability

The present invention can be applied to a method of manufacturing a mold for molding by using a three-dimensional molded object formed by an optical molding method, and to a method of manufacturing a molded article.

## Claims

1. A method of manufacturing a mold for molding comprising:
forming a cured resin layer by irradiating a coating film of a photo-curable liquid resin composition containing (A) to (C) mentioned below with light, and forming a three-dimensional molded object by successively laminating the cured resin layer;
forming a metal coating covering the three-dimensional molded object;
removing the three-dimensional molded object covered with the metal coating by an alkaline solution; and
taking the metal coating as the mold for molding;
the photo-curable liquid resin composition containing:
(A) a copolymer having alkali solubility containing the following structural units (a), (b), and (c):
(a) a structural unit derived from a polymerizable compound having a carboxyl group;
(b) a structural unit derived from a polymerizable compound having a phenolic hydroxyl group; and
(c) a structural unit derived from other polymerizable compounds;
(B) a compound having at least one ethylenic unsaturated double bond; and
(C) a radiation radical polymeric initiator.

2. The method of manufacturing a mold for molding according to Claim 1, wherein the photo-curable liquid resin composition further contains an organic solvent.

3. The method of manufacturing a mold for molding according to Claim 1 or 2, wherein the irradiation with light is performed such that a single projection is carried out for each projection area equal to or less than 100 mm².

4. The method of manufacturing a mold for molding according to any one of Claims 1 to 3, wherein the formation of the metal coating is performed by:
forming a primary film above the surface of the three-dimensional molded object; and
forming a metal coating above the primary film by an electroplating method.

5. A method of manufacturing a molded article, wherein a mold for molding formed by the manufacturing method according to any one of Claims 1 to 4 is pressed on resin.

6. The method of manufacturing a molded article according to Claim 5, comprising:
filling the mold for molding with resin;
separating the mold for molding and the resin; and
taking the resin as the molded article.
